(19) Europäisches Patentamt / European Patent Office / Office européen des brevets

(11) **EP 4 458 491 A1**

(12) **EUROPEAN PATENT APPLICATION**
published in accordance with Art. 153(4) EPC

(43) Date of publication:
**06.11.2024 Bulletin 2024/45**

(21) Application number: **22916190.6**

(22) Date of filing: **28.12.2022**

(51) International Patent Classification (IPC):
**B22F 3/00** (2021.01)   **B22F 1/00** (2022.01)
**B22F 3/14** (2006.01)   **B22F 7/08** (2006.01)

(52) Cooperative Patent Classification (CPC):
**B22F 1/00; B22F 3/00; B22F 3/14; B22F 7/08**

(86) International application number:
**PCT/JP2022/048667**

(87) International publication number:
**WO 2023/127968 (06.07.2023 Gazette 2023/27)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **28.12.2021   JP 2021215295**

(71) Applicant: **Mitsubishi Materials Corporation**
**Tokyo 100-8117 (JP)**

(72) Inventors:
• **MASUYAMA, Kotaro**
  **Naka-shi, Ibaraki 311-0102 (JP)**
• **NAKAYA, Kiyotaka**
  **Naka-shi, Ibaraki 311-0102 (JP)**

(74) Representative: **Gille Hrabal**
**Partnerschaftsgesellschaft mbB**
**Patentanwälte**
**Brucknerstraße 20**
**40593 Düsseldorf (DE)**

(54) **BONDING SHEET, METHOD FOR PRODUCING BONDING SHEET, AND METHOD FOR PRODUCING BONDED BODY**

(57)   To appropriately perform bonding while suppressing the fear of breakage. A bonding sheet (10) includes a sintered body of copper, and has a Young's modulus of 10 GPa or more and a filling rate of 50% or more and 70% or less.

## FIG.1

EP 4 458 491 A1

**Description**

Field

The present invention relates to a bonding sheet, a method for producing a bonding sheet, and a method for producing a bonded body.

Background

In the assembly, mounting, or the like of electronic components, a bonding material may be used when bonding two or more components. For example, Patent Literature 1 describes, as a bonding material, a bonding sheet formed by mixing copper particles and a solvent having a boiling point of 150°C or higher and performing pressing at normal temperature.

Citation List

Patent Literature

Patent Literature 1: JP 2021-116463 A

Summary

Technical Problem

For such a bonding sheet, it is required to suppress the fear of breakage in order to improve handling, and it is also required to be able to appropriately perform bonding.
The present invention has been made in view of the above, and an object of the present invention is to provide a bonding sheet, a method for producing a bonding sheet, and a method for producing a bonded body that allow bonding to be appropriately performed while suppressing the fear of breakage.

Solution to Problem

In order to solve the problem described above and achieve the object, a bonding sheet according to the present disclosure includes a sintered body of copper and has a Young's modulus of 10 GPa or more and a filling rate of 50% or more and 70% or less.
The bonding sheet according to the present disclosure preferably has a Young's modulus of 10 GPa or more and 30 GPa or less.
The bonding sheet according to the present disclosure preferably has an arithmetic average roughness Ra of a surface of 1 $\mu$m or more and 40 $\mu$m or less.
The bonding sheet according to the present disclosure preferably has a thermal conductivity of 10 W/mK or more and 60 W/mK or less.
In order to solve the problem described above and achieve the object, a method for producing a bonding sheet includes the steps of: putting a plurality of copper particles into a mold; and sintering the plurality of copper particles put in the mold by heating the copper particles at 150°C or higher and 250°C or lower for 1 minute or more and 30 minutes or less while compressing the copper particles at 10 MPa or more and 30 MPa or less, to produce a bonding sheet including a sintered body of copper and having a Young's modulus of 10 GPa or more and a filling rate of 50% or more and 70% or less.
In order to solve the problem described above and achieve the object, a method for producing a bonded body includes the steps of: placing the above-described bonding sheet on a first member; placing a second member on the bonding sheet to obtain a stacked body in which the bonding sheet is placed between the first member and the second member; and heating the stacked body to produce a bonded body in which the first member and the second member are bonded together.

Advantageous Effects of Invention

According to the present invention, bonding can be appropriately performed while the fear of breakage is suppressed.

Brief Description of Drawings

FIG. 1 is a schematic diagram of a bonding sheet according to the present embodiment.
FIG. 2 is a schematic partially enlarged view of the bonding sheet.
FIG. 3 is a flowchart describing a method for producing a bonding sheet according to the present embodiment.
FIG. 4 is a schematic diagram for describing a method for producing a bonded body.
FIG. 5 is a table illustrating characteristics and evaluation results of bonding sheets of examples. Description of Embodiments

Hereinbelow, the present invention is described in detail with reference to the drawings. Note that the present invention is not limited by the following modes for carrying out the invention (hereinafter, referred to as embodiments). Further, the constituent elements in the following embodiments include those that can be easily conceived by those skilled in the art and those that are substantially the same, that is, those within what is called the equivalent scope. Further, the constituent elements disclosed in the following embodiments can be combined as appropriate.

Bonding Sheet

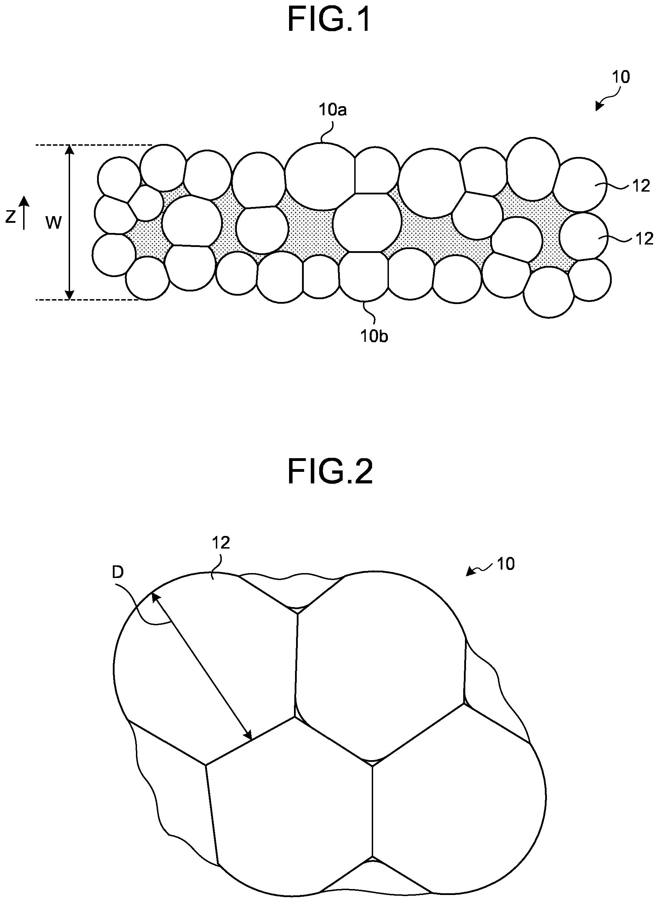

FIG. 1 is a schematic diagram of a bonding sheet according to the present embodiment. A bonding sheet 10 according to the present embodiment is a sheet-like member that bonds members together. As illustrated in FIG. 1, the bonding sheet 10 is a sintered body of copper, and has a structure in which a plurality of copper particles 12 are bonded together by sintering. The bonding sheet 10 is preferably one that experiences further progress of sintering when heated at 150°C to 300°C (150°C or higher and 300°C or lower). That is, it can be said that the bonding sheet 10 is a temporarily sintered body of copper. Here, the progress of sintering refers to an increase in filling rate due to further advance in bonding of copper particles 12. Since the bonding sheet 10 is a temporarily sintered body, the Young's modulus can be kept high, the fear of breakage can be suppressed, and the members can be appropriately bonded together by advancing sintering. The bonding sheet 10 needs only to include a temporarily sintered body of copper, and may partially include notsintered copper particles.

The filling rate of the bonding sheet 10 is 50% or more and 70% or less, preferably 52% or more and 68% or less, and more preferably 55% or more and 65% or less. By the filling rate being in this range, further sintering can be caused to appropriately progress while the Young's modulus is kept high, and the members can be appropriately bonded together.

The filling rate is the ratio of the bulk density to the true density (bulk density/true density). The true density herein refers to the density of the substance (herein, copper) itself when it is assumed that there are no pores, cracks, or the like in the sintered body, that is, a theoretical density. The bulk density refers to a value obtained by dividing the weight of the bonding sheet 10 by the volume obtained from the outer dimensions of the bonding sheet 10. The volume obtained from the outer dimensions refers to the total volume including pores of the bonding sheet 10.

As the true density, for example, a literature value of the density of copper (for example, 8.96 g/cm$^3$) can be used. The bulk density can be measured using a balance, a three-dimensional measurement machine, and a micrometer. For example, the area and the thickness of the bonding sheet 10 are measured with a three-dimensional measurement machine and a micrometer, and a value obtained by multiplying the area and the thickness is taken as the volume obtained from the outer dimensions. Then, the weight of the bonding sheet 10 is measured with a balance, and a value obtained by dividing the measured weight by the volume obtained from the outer dimensions is taken as the bulk density.

As described later, in the bonding sheet 10, a sintered body of copper may be impregnated with a resin. The filling rate in this case refers to the filling rate of the sintered body of copper excluding the resin. In the following, characteristics of the bonding sheet 10 other than the filling rate are defined, and the characteristics may similarly refer to the characteristics of the sintered body of copper excluding the resin.

For the bonding sheet 10, the arithmetic average roughness Ra of surface 10a that is a major surface on one side and surface 10b that is a major surface on the other side is preferably 1 μm or more and 40 μm or less, more preferably 1 μm or more and 35 μm or less, and still more preferably 1 μm or more and 30 μm or less. The bonding sheet 10 may also have a configuration in which the arithmetic average roughness Ra of at least one of surface 10a and surface 10b is in the above range. By the arithmetic average roughness Ra (surface roughness) being in this range, further sintering can be caused to appropriately progress, and the members can be appropriately bonded together.

The arithmetic average roughness Ra can be measured according to a provision of JIS B 0601: 2001.

FIG. 2 is a schematic partially enlarged view of the bonding sheet. For the bonding sheet 10, the average particle diameter, which is the average value of the particle diameters D of the copper particles 12, is preferably 100 nm or more and 350 nm or less, more preferably 150 nm or more and 300 nm or less, and still more preferably 200 nm or more and 250 nm or less. By the average particle diameter being in this range, the surface area of the bonding sheet 10 can be kept large, and further sintering can be caused to appropriately progress.

Since copper particles 12 are bonded together by sintering in the bonding sheet 10, the average particle diameter of the copper particles 12 can be said to be the average value of the particle diameters of the copper particles 12 existing in partitioned areas that are created through partitioning of the bonding sheet 10 at the interfaces of bonded copper particles 12.

For example, a BET diameter calculated based on a BET specific surface area may be taken as the average particle diameter of the copper particles 12. In this case, the specific surface area of the bonding sheet 10 was obtained according to the BET method by measuring the amount of nitrogen gas adsorbed on the bonding sheet 10 by using a specific surface area measurement apparatus (Quantachrome Autosorb-1, manufactured by Quantachrome Instruments, Inc.). Using the obtained specific surface area S ($m^2/g$) and the density $\rho$ ($g/cm^3$) of the copper particle, the BET diameter may be calculated by the following formula; the resulting value may be taken as the average particle diameter of the copper particles 12.

$$\texttt{BET diameter (nm) = 6000/($\rho$ (g/cm}^3\texttt{) $\times$ S (m}^2\texttt{/g))}$$

The Young's modulus of the bonding sheet 10 is 10 GPa or more, preferably 10 GPa or more and 30 GPa or less, more preferably 11 GPa or more and 20 GPa or less, and still more preferably 12 GPa or more and 15 GPa or less. By the Young's modulus being in this range, the fear of breakage can be suppressed.

The Young's modulus can be measured using PICODENTOR HM500 (manufactured by Fischer Instruments K.K.; the analysis software application being WIN-HCU ver. 7.0), which is an apparatus conforming to ISO 14577, which is a standard of the nanoindentation method. The nanoindentation method is a technique that calculates hardness or Young's modulus from a load applied to a sample and an indentation depth.

In the present embodiment, the average value of indentation Young's moduli obtained by using the above apparatus and analysis software application to perform measurement on randomly selected five places of the upper surface of the bonding sheet 10, i.e., perform a total of five times of measurement, is taken as the Young's modulus of the bonding sheet 10. For the measurement conditions, measurement was performed by using a Vickers indenter as a terminal and setting the indentation depth to 2 $\mu$m, the indentation speed to 0.067 $\mu$m/sec, and the measurement temperature to 25°C, in a state where the bonding sheet 10 was put on a silicon wafer having a larger size than the bonding sheet 10 and a thickness of 0.4 mm. The Young's moduli hereinafter may refer to measurement values based on similar methods.

The thermal conductivity of the bonding sheet 10 is preferably 10 W/mK or more and 60 W/mK or less, more preferably 15 W/mK or more and 55 W/mK or less, and still more preferably 20 W/mK or more and 50 W/mK or less. By the thermal conductivity being in this range, the heat of the members to be bonded can be suitably transferred.

The thermal conductivity can be obtained by, for example, conversion from specific resistance. Specifically, the sheet resistance at 25°C of a bonding sheet formed in 10 mm × 10 mm is measured by a four-point probe method using Loresta (MCP-250T, manufactured by Mitsubishi Petrochemical Co., Ltd.), and the sheet resistance is multiplied by the sheet film thickness to calculate the specific resistance. The thermal conductivity at 25°C is obtained by using the Wiedemann-Franz law to convert the specific resistance.

The thickness W of the bonding sheet 10 is preferably 0.1 mm or more and 1 mm or less, more preferably 0.2 mm or more and 0.7 mm or less, and still more preferably 0.3 mm or more and 0.5 mm or less. As illustrated in FIG. 1, the thickness W refers to the distance in the direction Z, which is the thickness direction, between a portion of surface 10a that protrudes most from surface 10a and a portion of surface 10b that protrudes most from surface 10b.

The projection area of the bonding sheet 10 as projected in direction Z is preferably 10000 $mm^2$ or less, more preferably 6400 $mm^2$ or less, and still more preferably 3600 $mm^2$ or less.

By forming a bonding sheet 10 having a thickness W and a projection area in these ranges, the members can be appropriately bonded together.

A value (thickness W/filling rate) obtained by dividing the thickness W of the bonding sheet 10 by the filling rate (%) of the bonding sheet 10 is defined as a large area bonding index D1. In this case, the large area bonding index D1 is preferably 1.50 or more and 10.0 or less, and more preferably 4.0 or more and 8.0 or less.

By the large area bonding index D1 being in this range, the members can be appropriately bonded together while breakage is suppressed.

In the bonding sheet 10, a sintered body of copper may be impregnated with a resin. That is, in the bonding sheet 10, at least some of the interiors of the internal pores may be filled with a resin. Examples of the resin herein include epoxy resins and silicone resins. By impregnation with a resin, the bonding sheet 10 can be provided with an appropriate function.

Method for Producing Bonding Sheet

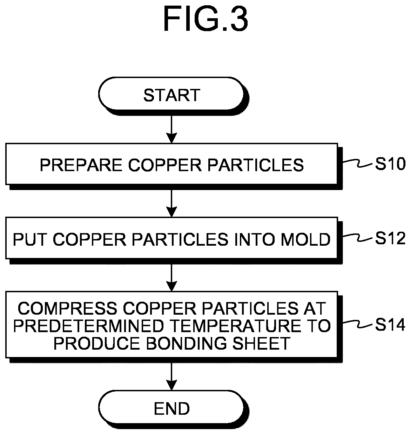

FIG. 3 is a flowchart describing a method for producing a bonding sheet according to the present embodiment.

Preparation of Copper Particles

As illustrated in FIG. 3, in the present producing method, first, copper particles 12A are prepared (step S10). The copper particles 12A herein are particles of copper serving as a source material of the bonding sheet 10, and can also be said to be a powder of copper before temporary sintering. That is, by temporarily sintering the copper particles 12A, a bonding sheet 10 in which copper particles 12 are bonded together by temporary sintering is produced. It can be said that copper particles before temporary sintering are copper particles 12A and copper particles after temporary sintering are copper particles 12.

The BET diameter of the copper particle 12A is preferably 50 nm or more and 300 nm or less. The BET diameter is a particle diameter calculated from the BET specific surface area of the copper particles obtained by the BET method and the true density, with the copper particle 12A regarded as a perfect sphere or a cube. Specifically, the BET diameter can be obtained by a method described in Examples described later.

When the BET diameter of the copper particle 12A is 50 nm or more, a strong aggregate is less likely to be formed. Therefore, the surface of the copper particle 12 after temporary sintering can be uniformly covered with a solvent 20 described later. On the other hand, when the BET diameter of the copper particle 12A is 300 nm or less, the reaction area is large and sintering ability based on heating is high, and therefore a strong bonding layer can be formed. The BET diameter of the copper particle 12A is preferably in the range of 80 nm or more and 200 nm or less, and particularly preferably in the range of 80 nm or more and 170 nm or less.

The BET specific surface area of the copper particles 12A is preferably in the range of 2.0 m$^2$/g or more and 8.0 m$^2$/g or less, more preferably in the range of 3.5 m$^2$/g or more and 8.0 m$^2$/g or less, and particularly preferably in the range of 4.0 m$^2$/g or more and 8.0 m$^2$/g or less. The shape of the copper particle 12A is not limited to a spherical shape, and may be a needle-like shape or a flat plate-like shape.

The surface of the copper particle 12A is preferably covered with an organic protective film that is a film of an organic substance. By covering with an organic protective film, oxidation of the copper particle 12A is suppressed, and a reduction in sintering ability due to oxidation of the copper particle 12A is still less likely to occur. The organic protective film covering the copper particle 12A is not formed by a solvent 20, and can be said to not be derived from the solvent 20. The organic protective film covering the copper particle 12A can also be said to not be a film of copper oxide formed by oxidation of copper.

The fact that the copper particle 12A is covered with an organic protective film can be determined by using time-of-flight secondary ion mass spectrometry (TOF-SIMS) to analyze the surface of the copper particle 12A. Thus, in the present embodiment, for the copper particle 12A, the ratio ($C_3H_3O_3^-$/$Cu^+$ ratio) of the amount of $C_3H_3O_3^-$ ions detected to the amount of $Cu^+$ ions detected, which ions are detected by using time-of-flight secondary ion mass spectrometry to analyze the surface, is preferably 0.001 or more. The $C_3H_3O_3^-$/$Cu^+$ ratio is more preferably in the range of 0.05 or more and 0.2 or less. The surface of the copper particle 12A in the present analysis refers not to the surface of the copper particle 12A when the organic protective film is removed from the copper particle 12A, but to the surface of the copper particle 12A including the covering organic protective film (that is, the surface of the organic protective film).

For the copper particle 12A, $C_3H_4O_2^-$ ions or $C_5$-or-more ions may be detected by using time-of-flight secondary ion mass spectrometry to analyze the surface. The ratio ($C_3H_4O_2^-$/$Cu^+$ ratio) of the amount of $C_3H_4O_2^-$ ions detected to the amount of $Cu^+$ ions detected is preferably 0.001 or more. The ratio ($C_5$-or-more ions/$Cu^+$ ratio) of the amount of $C_5$-or-more ions detected to the amount of $Cu^+$ ions detected is preferably less than 0.005.

The $C_3H_3O_3^-$ ion, the $C_3H_4O_2^-$ ion, and the $C_5$-or-more ion detected in time-of-flight secondary ion mass spectrometry are derived from the organic protective film covering the surface of the copper particle 12A. Thus, when each of the $C_3H_3O_3^-$/$Cu^+$ ratio and the $C_3H_4O_2^-$/$Cu^+$ ratio is 0.001 or more, the surface of the copper particle 12A is less likely to be oxidized, and copper particles 12A are less likely to be aggregated. Further, when each of the $C_3H_3O_3^-$/$Cu^+$ ratio and the $C_3H_4O_2^-$/$Cu^+$ ratio is 0.2 or less, oxidation and aggregation of copper particles 12A can be suppressed without excessively reducing the sintering ability of the copper particles 12A, and generation of decomposition gas of the organic protective film during heating can be suppressed; thus, a bonding layer having a small amount of voids can be formed. In order to still further improve the oxidation resistance of the copper particle 12A during storage and still further improve sintering ability at low temperature, each of the $C_3H_3O_3^-$/$Cu^+$ ratio and the $C_3H_4O_2^-$/$Cu^+$ ratio is preferably in the range of 0.08 or more and 0.16 or less. Further, when the $C_5$-or-more ions/$Cu^+$ ratio is 0.005 or more, a large amount of organic protective films having relatively high desorption temperatures are present on the particle surfaces, and consequently sintering ability is not sufficiently exhibited and a strong bonding layer is hard to obtain. The $C_5$-or-more ions/$Cu^+$ ratio is preferably less than 0.003.

The organic protective film is preferably derived from citric acid. A method for producing copper particles 12A covered with organic protective films derived from citric acid will be described later. The amount of the covering of the organic protective film of the copper particle 12A is, with respect to 100 mass% of the copper particle, preferably in the range of 0.5 mass% or more and 2.0 mass% or less, more preferably in the range of 0.8 mass% or more and 1.8 mass% or less, and still more preferably in the range of 0.8 mass% or more and 1.5 mass% or less. By the amount of the covering of the organic protective film being 0.5 mass% or more, the copper particle 12A can be uniformly covered with the organic protective film, and oxidation of the copper particle 12A can be more reliably suppressed. By the amount of the covering of the organic protective film being 2.0 mass% or less, a situation where voids are generated in a sintered body of copper particles (the bonding layer) due to gas generated by decomposition of the organic protective film by heating can be suppressed. The amount of the covering of the organic protective film can be measured using a commercially available apparatus. For example, the amount of the covering can be measured using a differential thermal balance, TG8120-SL (manufactured by Rigaku Corporation). In this case, for example, copper particles from which moisture is removed by freeze-drying are used as a sample. The rate of weight reduction measured when heating is performed from 250°C to 300°C with the rate of temperature increase set to 10°C/min in nitrogen (the G2 grade) gas, which is for the purpose of suppressing oxidation of copper particles, can be defined as the amount of the covering of the organic protective film. That is, the amount of the covering = (the weight of the sample after measurement)/(the weight of the sample before measurement) $\times$ 100 (wt%). The measurement may be performed three times on copper particles of the same lot, and the arithmetic mean value may be taken as the amount of the covering.

For the copper particle 12A, it is preferable that, when heating is performed at a temperature of 300°C for 30 minutes in an atmosphere of an inert gas such as argon gas, 50 mass% or more of the organic protective film be decomposed. An organic protective film derived from citric acid generates, during decomposition, carbon dioxide gas, nitrogen gas, evaporative gas of acetone, and water vapor.

Copper particles 12A covered with organic protective films derived from citric acid can be produced as follows, for example. First, an aqueous dispersion of copper citrate is prepared, and a pH adjuster is added to the copper citrate aqueous dispersion to adjust the pH to 2.0 or more and 7.5 or less. Next, in an inert gas atmosphere, 1.0 equivalent or more and 1.2 equivalents or less of a hydrazine compound capable of reducing copper ions is, as a reducing agent, added to and mixed with the copper citrate aqueous dispersion subjected to pH adjustment. In an inert gas atmosphere, the obtained mixed solution is heated to a temperature of 60°C or higher and 80°C or lower, and is held for 1.5 hours or more and 2.5 hours or less. Thereby, copper ions dissolved out from copper citrate are reduced to generate copper particles 12A, and organic protective films derived from citric acid are formed on the surfaces of the copper particles 12A.

The aqueous dispersion of copper citrate can be prepared by a process in which copper citrate in a powder form is added to pure water such as distilled water or ionexchanged water to have a concentration of 25 mass% or more and 40 mass% or less and a stirring blade is used to perform stirring to perform uniform dispersion. Examples of the pH adjuster include triammonium citrate, ammonium hydrogen citrate, citric acid, and the like. Among them, triammonium citrate is preferable because it can easily perform mild pH adjustment. The operation of setting the pH of the copper citrate aqueous dispersion to 2.0 or more is in order to increase the rate of dissolution-out of copper ions dissolved out from copper citrate and cause generation of copper particles to rapidly progress, and thus obtain desired fine copper particles 12A. The operation of setting the pH to 7.5 or less is in order to suppress formation of copper(II) hydroxide from dissolvedout copper ions and increase the yield of copper particles 12A. Further, by setting the pH to 7.5 or less, an excessive increase in the reducing power of the hydrazine compound can be suppressed, and desired copper particles 12A can be easily obtained. The pH of the copper citrate aqueous dispersion is preferably adjusted within the range of 4 or more and 6 or less.

The reduction of copper citrate by the hydrazine compound is performed in an inert gas atmosphere. This is in order to prevent oxidation of copper ions dissolved out into the solution. Examples of the inert gas include nitrogen gas, argon gas, and the like. The hydrazine compound has advantages that, when reducing copper citrate under acidity, no residue is generated after the reduction reaction, that safety is relatively high, that handling is easy, etc. Examples of the hydrazine compound include hydrazine monohydrate, anhydrous hydrazine, hydrazine hydrochloride, hydrazine sulfate, and the like. Among these hydrazine compounds, hydrazine monohydrate and anhydrous hydrazine, which do not contain components that can be impurities, such as sulfur or chlorine, are preferable.

In general, copper generated in an acidic solution having a pH of less than 7 will be dissolved. However, in the present embodiment, a hydrazine compound that is a reducing agent is added to and mixed with an acidic solution having a pH of less than 7, and copper particles 12A are generated in the obtained mixed solution. Therefore, citric acid-derived components generated from copper citrate rapidly cover the surface of the copper particle 12A, and thus dissolution of copper particles 12A is suppressed. The aqueous dispersion of copper citrate after subjected to pH adjustment is preferably adjusted to a temperature of 50°C or higher and 70°C or lower to facilitate the progress of reduction reaction.

The operation in which, in an inert gas atmosphere, a mixed solution in which a hydrazine compound is mixed is heated to a temperature of 60°C or higher and 80°C or lower and is held for 1.5 hours or more and 2.5 hours or less is in order to generate copper particles 12A and to form an organic protective film on the surface of the generated copper particle 12A to perform covering. The operation of performing heating and holding in an inert gas atmosphere is in order to prevent oxidation of the generated copper particles 12A. Copper citrate, which is a starting material, usually contains about 35 mass% of the copper component. By a process in which a hydrazine compound that is a reducing agent is added to a copper citrate aqueous dispersion containing such a level of the copper component, heating is performed at the above temperature, and holding is performed for the above period of time, the generation of copper particles 12A and the generation of organic protective films on the surfaces of the copper particles 12A progress with good balanced, and thus copper particles 12A in each of which the amount of the covering of the organic protective film is in the range of 0.5 mass% or more and 2.0 mass% or less with respect to 100 mass% of the copper particle can be obtained. When the heating temperature is lower than 60°C and the holding time is less than 1.5 hours, copper citrate is not completely reduced and the rate of generation of copper particles 12A is too low, and it is feared that the amount of the organic protective film covering the copper particle 12A will be excessive. When the heating temperature is higher than 80°C and the holding time is more than 2.5 hours, the rate of generation of copper particles 12A is too high, and it is feared that the amount of the organic protective film covering the copper particle 12A will be too small. Preferred heating temperatures are 65°C or higher and 75°C or lower, and preferred periods of holding time are 2 hours or more and 2.5 hours or less.

The copper particles 12A generated in the mixed solution are subjected to solid-liquid separation from the mixed solution in an inert gas atmosphere by using, for example, a centrifuge, and drying is performed by a freeze-drying method or a reduced-pressure drying method; thereby, copper particles 12A of which the surfaces are covered with organic protective films are obtained. Since the surface of the copper particle 12A is covered with an organic protective film, the copper particle 12A is less likely to be oxidized even when stored in the air until put to use as the bonding sheet 10.

Putting of Copper Particles into Mold

Next, as illustrated in FIG. 3, the prepared copper particles 12A are put into a mold (step S12). The shape and material of the mold to be filled with copper particles 12A may be arbitrary.

Temporary Sintering of Copper Particles

Next, the copper particles 12A put in the mold are compressed at a predetermined temperature to be temporarily sintered, and thereby a bonding sheet 10 is produced (step S14). In this step, the copper particles 12A put in the mold are held at a predetermined temperature for a predetermined period of time while being compressed at a predetermined pressure, and thereby the copper particles 12A are temporarily sintered to produce a bonding sheet 10. The predetermined pressure herein is preferably 10 MPa or more and 30 MPa or less, more preferably 11 MPa or more and 25 MPa or less, and still more preferably 12 MPa or more and 20 MPa or less. The predetermined temperature herein is preferably 150°C or higher and 250°C or lower, more preferably 160°C or higher and 240°C or lower, and still more preferably 170°C or higher and 230°C or lower. The predetermined period of time (the period of time during which holding is performed at a predetermined pressure and a predetermined temperature) herein is preferably 1 minute or more and 30 minutes or less, more preferably 2 minutes or more and 25 minutes or less, and still more preferably 3 minutes or more and 20 minutes or less.

By temporarily sintering the copper particles 12A under such conditions, a bonding sheet 10 capable of suppressing the fear of breakage can be appropriately produced.

The bonding sheet 10 is not limited to being produced by the above method, and the method for producing the bonding sheet 10 may be arbitrary.

Method for Producing Bonded Body

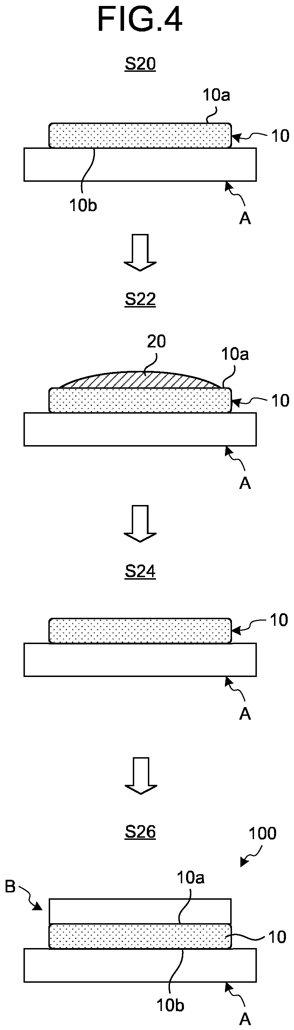

Next, a method in which the bonding sheet 10 is used to bond members together to produce a bonded body 100 is described. FIG. 4 is a schematic diagram for describing a method for producing a bonded body. In the present embodiment, the bonding sheet 10 is used as a bonding layer to bond a first member A and a second member B together, and thus a bonded body 100 is produced. The first member A and the second member B may be arbitrary members; for example, one of the first member A and the second substrate B may be a substrate, and the other may be an electronic component. That is, a semiconductor module in which a substrate and an electronic component are bonded together by a bonding layer may be produced as the bonded body 100. The substrate is not particularly limited, and examples include an oxygen-free copper plate, a copper-molybdenum plate, a high heat dissipation insulating substrate (for example, a DCB (direct copper bond)), a base material for mounting a semiconductor element such as an LED (light emitting diode) package, and the like. Examples of the electronic component include semiconductor elements such as an IGBT (insulated gate bipolar transistor), a diode, a Schottky barrier diode, a MOS-FET (metal-oxide-semiconductor field effect transistor), a thyristor, a logic, a sensor, an analog integrated circuit, an LED, a semiconductor laser, and a transmitter.

In the present producing method, as illustrated in step S20 of FIG. 4, the bonding sheet 10 is placed on a surface of the first member A. In the example of FIG. 4, the bonding sheet 10 is placed on the first member A such that surface 10b of the bonding sheet 10 is in contact with a surface of the first member A.

Next, as illustrated in step S22, a solvent 20 is applied onto surface 10a (a surface on a side not in contact with the first member A) of the bonding sheet 10. The solvent 20 acts as a binder for copper particles 12. The solvent 20 is an organic solvent. The addition of the solvent 20 is not indispensable.

The boiling point of the solvent 20 is preferably 150°C or higher and preferably 200°C or lower. The boiling point of the solvent 20 is more preferably 150°C or higher and 300°C or lower, and still more preferably 200°C or higher and 250°C or lower. The molecular weight of the solvent 20 is preferably in the range of 100 or more and 1000 or less, more preferably in the range of 200 or more and 800 or less, and particularly preferably in the range of 200 or more and 600 or less. The solvent is preferably a compound having a reducing group at a terminal. The reducing group is preferably a hydroxy group. The permittivity of the solvent 20 is preferably 4 or more and 80 or less, more preferably 10 or more and 45 or less, and still more preferably 20 or more and 40 or less. The permittivity may be measured with a liquid permittivity measurement instrument (Model 871, manufactured by Nihon Rufuto Co., Ltd.).

As the solvent 20, for example, a diol compound or a triol compound can be used. Examples of the diol compound include ethylene glycol, diethylene glycol, and polyethylene glycol. Examples of the triol compound include glycerin, butanetriol, and polyoxypropylenetriol. For these organic solvents and polymer solvents, one kind may be used singly, or two or more kinds may be used in combination.

The solvent 20 is added at a mass ratio to the bonding sheet 10 of preferably 0.5% or more and 10% or less, preferably 1% or more and 8% or less, and more preferably 2% or more and 5% or less. By the amount of the solvent 20 added being in this range, bonding ability can be appropriately kept.

As illustrated in step S24, the solvent 20 enters pores of the bonding sheet 10, and is put in the pores. That is, it can be said that the bonding sheet 10 transitions to a state of being impregnated with the solvent 20.

After that, as illustrated in step S26, the second member B is placed on surface 10a of the bonding sheet 10 impregnated with the solvent 20. That is, a state where the bonding sheet 10 impregnated with the solvent 20 is placed between the first member A and the second member B is created.

After that, the stacked body in which the bonding sheet 10 is placed between the first member A and the second member B is heated to cause sintering of the bonding sheet 10 to further progress; thus, a bonded body 100 in which the first member A and the second member B are bonded together by a bonding layer (the sintered bonding sheet 10) is produced. The heating temperature of the stacked body may be, for example, in the range of 150°C or higher and 300°C or lower. The heating time of the stacked body may be, for example, in the range of 10 minutes or more and 1 hour or less. The heating of the stacked body is preferably performed while the stacked body is compressed in the stacking direction of the stacked body in an inert gas atmosphere. As the inert gas, nitrogen gas or argon gas can be used. The compression pressure of the stacked body is preferably in the range of 0.5 MPa or more and 30 MPa or less.

Effects

As described hereinabove, a bonding sheet 10 according to the present embodiment includes a sintered body of copper, and has a Young's modulus of 10 GPa or more and a filling rate of 50% or more and 70% or less. By being a sintered body of copper having a Young's modulus of 10 GPa or more, the bonding sheet 10 can have sufficient strength, and can suppress breakage. Further, by being a temporarily sintered body having a filling rate of 50% or more and 75% or less, the bonding sheet 10 can cause sintering to further progress during bonding of members, and can appropriately bond the members together.

The Young's modulus of the bonding sheet 10 is preferably 10 GPa or more and 30 GPa or less. By the Young's modulus being in this range, breakage can be more suitably suppressed.

The arithmetic average roughness Ra of the surface of the bonding sheet 10 is preferably 1 μm or more and 40 μm or less. By virtue of a temporarily sintered body having a surface roughness in this range, sintering can be caused to further progress during bonding of members, and the members can be appropriately bonded together.

The thermal conductivity of the bonding sheet 10 is preferably 10 W/mK or more and 60 W/mK or less. By the thermal conductivity being in this range, the heat conductivity of the bonded body 100 can be appropriately secured.

A method for producing a bonding sheet 10 according to the present embodiment includes: a step of putting a plurality of copper particles 12A into a mold; and a step of sintering the plurality of copper particles 12A put in the mold by, while compressing the copper particles 12A at 10 MPa or more and 30 MPa or less, heating the copper particles 12A at 150°C or higher and 250°C or lower for 1 minute or more and 30 minutes or less, and thereby producing a bonding sheet 10 including a sintered body of copper and having a Young's modulus of 10 GPa or more and a filling rate of 50% or more and 70% or less. By the present producing method, a bonding sheet 10 capable of suppressing breakage can be produced.

A method for producing a bonded body 100 according to the present embodiment includes: a step of placing the bonding sheet 10 on a first member A; a step of placing a second member B on the bonding sheet 10 to obtain a stacked body in which the bonding sheet is placed between the first member and the second member; and a step of heating the stacked body to produce a bonded body 100 in which the first member A and the second member B are bonded together. By the present producing method, a bonded body 100 can be appropriately produced by using the bonding sheet 10.

Examples

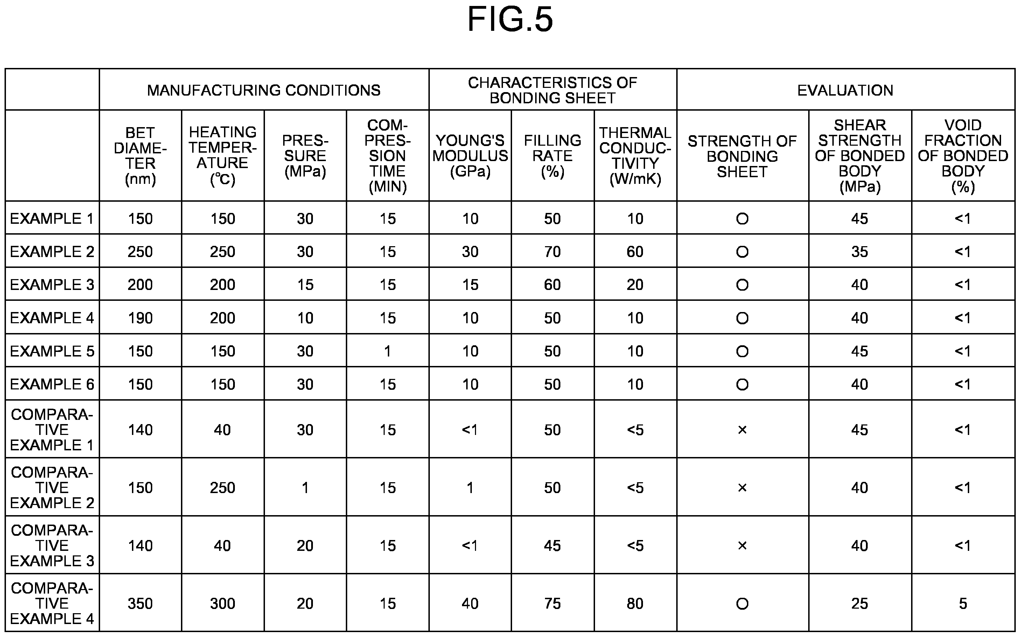

Next, Examples are described. FIG. 5 is a table illustrating characteristics and evaluation results of bonding sheets of examples.

Example 1

Preparation of Copper Particles

In Example 1, copper citrate 2.5-hydrate (manufactured by FUJIFILM Wako Pure Chemical Corporation) and ionexchanged water were stirred and mixed using a stirring blade, and an aqueous dispersion of copper citrate having a concentration of 30 mass% was prepared. Next, an ammonium citrate aqueous solution as a pH adjuster was added to the obtained copper citrate aqueous dispersion to adjust the pH of the copper citrate aqueous dispersion to 5. Next, the temperature of the obtained copper citrate aqueous dispersion was increased to 50°C; while the temperature was held, a hydrazine monohydrate aqueous solution (2-fold dilution) as a copper ion reducing agent was added at one time in a nitrogen gas atmosphere, and stirring and mixing were performed using a stirring blade. The amount of the hydrazine monohydrate aqueous solution added was set to 1.2 equivalents with respect to the amount necessary to reduce the total amount of copper ions. The temperature of the obtained mixed solution was increased to 70°C in a nitrogen gas atmosphere, and holding was performed at this temperature for 2 hours to generate copper particles. The generated copper particles were collected using a centrifuge. The collected copper particles were dried by a reduced-pressure drying method, and copper particles were produced.

A specific surface area measurement apparatus (Quantachrome Autosorb-1, manufactured by Quantachrome Instruments, Inc.) was used. The adsorbed gas was removed in advance at a degassing temperature of 50°C for a period of degassing time of 60 minutes; then, the amount of nitrogen gas adsorbed on copper particles was measured, and the specific surface area of the copper particles was obtained by the BET method. Using the obtained specific surface area S ($m^2/g$) and the density $\rho$ ($g/cm^3$) of the copper particle, the BET diameter was calculated by the following formula.

$$\text{BET diameter (nm)} = 6000/(\rho \ (g/cm^3) \times S \ (m^2/g))$$

Production of Bonding Sheet

An aluminum frame having outer dimensions of a 50-mm square $\times$ 30 mm and having a hole with inner dimensions of a 30-mm square $\times$ 30 mm was prepared as a mold to be filled with the prepared copper particles. The aluminum frame was filled with 1.5 g of copper particles, and uniform leveling was performed with an aluminum block of a 30-mm square $\times$ 20 mm; then, hot press treatment was performed in the air for 15 minutes under the conditions of an applied pressure of 30 MPa and a heating temperature of 150°C; thus, a bonding sheet was produced. CYPT-50KN (manufactured by Sintokogio, Ltd.) was used as a hot press apparatus. After the hot press treatment, cooling was performed to room temperature, and the bonding sheet of a 30-mm square $\times$ 0.4 mm sandwiched between the aluminum blocks was peeled off from the aluminum blocks; thus, a desired bonding sheet was obtained.

Characteristics of Bonding Sheet

The Young's modulus of the bonding sheet was measured using a picodenter. As a method for measuring the Young's modulus, the method described in the present embodiment was used.

Further, the filling rate of the bonding sheet was measured. The filling rate was measured as follows. The volume obtained from the outer dimensions of the bonding sheet was measured using vernier calipers and a micrometer. Specifically, measurement was performed on five pairs of points randomly selected on the two sides in each of the horizontal directions of the bonding sheet, and the product of the average values for the pairs of sides was taken as the area of the bonding sheet. Further, the thicknesses of the bonding sheet was measured on randomly selected 10 points with a micrometer, and the average value was taken as the thickness of the bonding sheet. The product of the area and the thickness was taken as the volume obtained from the outer dimensions of the bonding sheet. Next, the weight of the bonding sheet was measured. Then, a value obtained by dividing the weight of the bonding sheet by the volume obtained from the outer dimensions of the bonding sheet 10 was calculated as a bulk density. The volume obtained from the outer dimensions refers to the total volume including pores of the bonding sheet 10. Then, assuming that the true density is 8.96 g/cm3, the ratio of the bulk density to the true density was calculated as a filling rate.

Further, the thermal conductivity of the bonding sheet was measured. Specifically, the sheet resistance at 25°C of a bonding sheet formed in 10 mm × 10 mm was measured by a four-point probe method using Loresta (MCP-250T, manufactured by Mitsubishi Petrochemical Co., Ltd.), and the sheet resistance was multiplied by the sheet film thickness to calculate the specific resistance. The thermal conductivity at 25°C was obtained by using the Wiedemann-Franz law to convert the specific resistance.

The measured values of the Young's modulus, the filling rate, and the thermal conductivity are illustrated in FIG. 5.

Examples 2 to 6

In Example 2, a bonding sheet was produced by a similar method to Example 1 except that at least one of the heating temperature, the applied pressure, and the compression time was changed as in FIG. 5. The measured values of the Young's modulus, the filling rate, and the thermal conductivity are illustrated in FIG. 5.

Comparative Examples 1 to 4

In Comparative Examples 1 to 4, bonding sheets were produced by similar methods to Example 1 except that at least one of the heating temperature, the applied pressure, and the compression time was changed as in FIG. 5. The measured values of the Young's modulus, the filling rate, and the thermal conductivity are illustrated in FIG. 5.

Evaluation

Evaluation of Bonding Sheet

The strength of the bonding sheet of each example was evaluated. A bonding sheet of 30 mm × 30 mm was put on an oxygen-free copper plate of 50 mm × 50 mm × 1 mm in thickness, and 20-mm-diameter zirconia beads (YTZ-20, Nikkato Corporation) were gently dropped from a height of 30 mm, assuming that the height of a central portion of the upper surface of the bonding sheet was 0 mm. The operation of performing one time of dropping was repeated 10 times per sheet, and then the bonding sheet was visually observed; the case where the number of sheets on which no crack or chip was seen was seven or more was evaluated as passed (A), and the case where the number of sheets on which no crack or chip was seen was six or less was evaluated as failed (B).

Evaluation of Shear Strength of Bonded Body

The bonding sheet of each example was cut using a commercially available utility knife, and a bonding sheet piece (a 2.5-mm square × 500 $\mu$m in thickness) was produced. The bonding sheet piece (a 2.5-mm square × 500 $\mu$m in thickness) was placed on an oxygen-free copper substrate of a 30-mm square × 1 mm in thickness. Next, polyethylene glycol was, as a solvent, applied onto and made to permeate through the bonding sheet piece such that the amount of polyethylene glycol was 0.05 g per 0.95 g in weight of the sheet piece, and then an oxygen-free copper dummy element of a 2.5-mm square × 1 mm in thickness was placed. In this way, a stacked body in which the oxygen-free copper substrate and the oxygen-free copper dummy element were stacked via the bonding sheet piece was obtained. The obtained stacked body was held in a nitrogen gas atmosphere for 15 minutes under the conditions of a compression pressure of 5 MPa and a temperature of 300°C by using a die bonder (HTB-MM, manufactured by Alpha-Design Co., Ltd.), and thereby a bonded body (sample A) in which an oxygen-free copper substrate and an oxygen-free copper dummy element each in a size of a 2.5-mm square were bonded together via a copper bonding layer was produced.

The shear strength of the obtained bonded body (sample A) was measured by a method conforming to JIS Z 3198-7 (Namari-furi handa shiken hōhō - Dai 7 bu: Chippu buhin no handa tsugite sendan shiken hōhō (Lead-free solder test method - Part 7: Shear test method for a solder joint of a chip component)). Specifically, a load was applied to the oxygen-free copper dummy element by using a tool of a bond tester (Series 4000, manufactured by Nordson DAGE, Inc.), and the load (maximum shear load) when the oxygen-free copper dummy element was peeled off from the copper bonding layer was measured. The movement speed of the tool was set to 50 $\mu$m/sec, and the gap between the tip of the tool and the oxygen-free copper substrate was set to 50 $\mu$m. The obtained maximum shear load was converted into Newton, and was divided by the area of the copper bonding layer (2.5 mm × 2.5 mm); the resulting value was taken as the shear strength (unit: MPa). Seven bonded bodies were produced, and the shear strength was measured for each bonded body. The results are illustrated in FIG. 5.

In the evaluation, the case where the strength of the bonding sheet was evaluated as A and the shear strength of the bonded body was 30 MPa or more was evaluated as passed. On the other hand, the case where at least one of the strength of the bonding sheet being evaluated as A and the shear strength of the bonded body being 30 MPa or more was not satisfied was evaluated as failed.

As illustrated in FIG. 5, it can be seen that, in the bonding sheets of the Examples, each of which has a Young's modulus of 10 GPa or more and a filling rate of 50% or more and 70% or less, the strength of the bonded body is evaluated as passed, damage can be appropriately suppressed, and the shear strength is 30 MPa or more, and thus bonding can be appropriately performed. On the other hand, it can be seen that, in the bonding sheets of the Comparative Examples, in each of which at least one of the Young's modulus being 10 GPa or more and the filling rate being 50% or more and 70% or less is not satisfied, the strength or the shear strength is evaluated as failed, and it is not possible to achieve both suppression of damage and appropriate bonding.

Optional Evaluation

As optional evaluation, also a bonded body in which members were bonded together by using a bonding sheet was evaluated. Specifically, the void fraction of the bonded body was evaluated.

Void Fraction of Bonded Body

The bonding sheet was cut using a commercially available utility knife, and a bonding sheet piece (a 10-mm square × 500 μm in thickness) was produced. The bonding sheet piece (a 10-mm square × 500 μm in thickness) was placed on an oxygen-free copper substrate of a 30-mm square × 1 mm in thickness. Next, polyethylene glycol was, as a solvent, applied onto and made to permeate through the bonding sheet piece such that the amount of polyethylene glycol was 0.05 g per 0.95 g in weight of the sheet piece, and then an oxygen-free copper dummy element of a 10-mm square × 1 mm in thickness was placed. In this way, a stacked body in which the oxygen-free copper substrate and the oxygen-free copper dummy element were stacked via the bonding sheet piece was obtained. The obtained stacked body was held in a nitrogen gas atmosphere for 15 minutes under the conditions of at a compression pressure of 5 MPa and a temperature of 250°C by using a die bonder (HTB-MM, manufactured by Alpha-Design Co., Ltd.), and thereby a bonded body (sample B) in which an oxygen-free copper substrate and an oxygen-free copper dummy element each in a size of a 2.5 mm-square were bonded together via a copper bonding layer was produced.

For the copper bonding layer portion of the obtained bonded body (sample B), an ultrasonic flaw detection image was measured using an ultrasonic flaw detection apparatus (FINE-SAT, manufactured by Hitachi High-Technologies Corporation). The obtained ultrasonic flaw detection image was binarized using an image processing software application (Image J, manufactured by the National Institutes of Health of the U.S.), and was divided into voids (cavities) and a bonded body (copper particle sintered body), and the void fraction was calculated by the following formula.

Void fraction (%) = (the total area of void portions/the area of the copper bonding layer (10 mm × 10 mm) ) × 100

Seven bonded bodies were produced, and the void fraction was measured for each bonded body. The results are illustrated in FIG. 5.

Hereinabove, embodiments of the present invention are described; however, the embodiment is not limited by the contents of these embodiments. Further, the above-described constituent elements include those that can be easily conceived by those skilled in the art and those that are substantially the same, that is, those within what is called the equivalent scope. Further, the above-described constituent elements can be combined as appropriate. Further, various omissions, substitutions, or changes of constituent elements can be made without departing from the gist of the above-described embodiments.

Reference Signs List

10 Bonding sheet
12, 12A Copper particle

**Claims**

1.  A bonding sheet comprising

    a sintered body of copper,
    the bonding sheet having a Young's modulus of 10 GPa or more and a filling rate of 50% or more and 70% or less.

2.  The bonding sheet according to claim 1, having a Young's modulus of 10 GPa or more and 30 GPa or less.

3.  The bonding sheet according to claim 1 or 2, having an arithmetic average roughness Ra of a surface of 1 $\mu$m or more and 40 $\mu$m or less.

4.  The bonding sheet according to any one of claims 1 to 3, having a thermal conductivity of 10 W/mK or more and 60 W/mK or less.

5.  A method for producing a bonding sheet, the method comprising the steps of:

    putting a plurality of copper particles into a mold; and
    sintering the plurality of copper particles put in the mold by heating the copper particles at 150°C or higher and 250°C or lower for 1 minute or more and 30 minutes or less while compressing the copper particles at 10 MPa or more and 30 MPa or less, to produce a bonding sheet including a sintered body of copper and having a Young's modulus of 10 GPa or more and a filling rate of 50% or more and 70% or less.

6.  A method for producing a bonded body, the method comprising the steps of:

    placing the bonding sheet according to any one of claims 1 to 5 on a first member;
    placing a second member on the bonding sheet to obtain a stacked body in which the bonding sheet is placed between the first member and the second member; and
    heating the stacked body to produce a bonded body in which the first member and the second member are bonded together.

# FIG.1

# FIG.2

# FIG.3

```
                    ┌──────────────┐
                    │    START     │
                    └──────┬───────┘
                           │
                           ▼
        ┌─────────────────────────────────┐
        │    PREPARE COPPER PARTICLES      │───S10
        └─────────────────┬───────────────┘
                          │
                          ▼
        ┌─────────────────────────────────┐
        │   PUT COPPER PARTICLES INTO MOLD │───S12
        └─────────────────┬───────────────┘
                          │
                          ▼
        ┌─────────────────────────────────┐
        │   COMPRESS COPPER PARTICLES AT   │
        │ PREDETERMINED TEMPERATURE TO     │───S14
        │    PRODUCE BONDING SHEET         │
        └─────────────────┬───────────────┘
                          │
                          ▼
                   ┌──────────────┐
                   │     END      │
                   └──────────────┘
```

# FIG.4

S20

S22

S24

S26

## FIG.5

| | MANUFACTURING CONDITIONS | | | | CHARACTERISTICS OF BONDING SHEET | | | EVALUATION | | |
|---|---|---|---|---|---|---|---|---|---|---|
| | BET DIAME-TER (nm) | HEATING TEMPER-ATURE (°C) | PRES-SURE (MPa) | COM-PRES-SION TIME (MIN) | YOUNG'S MODULUS (GPa) | FILLING RATE (%) | THERMAL CONDUC-TIVITY (W/mK) | STRENGTH OF BONDING SHEET | SHEAR STRENGTH OF BONDED BODY (MPa) | VOID FRACTION OF BONDED BODY (%) |
| EXAMPLE 1 | 150 | 150 | 30 | 15 | 10 | 50 | 10 | ○ | 45 | <1 |
| EXAMPLE 2 | 250 | 250 | 30 | 15 | 30 | 70 | 60 | ○ | 35 | <1 |
| EXAMPLE 3 | 200 | 200 | 15 | 15 | 15 | 60 | 20 | ○ | 40 | <1 |
| EXAMPLE 4 | 190 | 200 | 10 | 15 | 10 | 50 | 10 | ○ | 40 | <1 |
| EXAMPLE 5 | 150 | 150 | 30 | 1 | 10 | 50 | 10 | ○ | 45 | <1 |
| EXAMPLE 6 | 150 | 150 | 30 | 15 | 10 | 50 | 10 | ○ | 40 | <1 |
| COMPARA-TIVE EXAMPLE 1 | 140 | 40 | 30 | 15 | <1 | 50 | <5 | × | 45 | <1 |
| COMPARA-TIVE EXAMPLE 2 | 150 | 250 | 1 | 15 | 1 | 50 | <5 | × | 40 | <1 |
| COMPARA-TIVE EXAMPLE 3 | 140 | 40 | 20 | 15 | <1 | 45 | <5 | × | 40 | <1 |
| COMPARA-TIVE EXAMPLE 4 | 350 | 300 | 20 | 15 | 40 | 75 | 80 | ○ | 25 | 5 |

## INTERNATIONAL SEARCH REPORT

International application No.

**PCT/JP2022/048667**

### A. CLASSIFICATION OF SUBJECT MATTER

*B22F 3/00*(2021.01)i; *B22F 1/00*(2022.01)i; *B22F 3/14*(2006.01)i; *B22F 7/08*(2006.01)i
FI:  B22F3/00 A; B22F1/00 L; B22F3/14 D; B22F7/08 C

According to International Patent Classification (IPC) or to both national classification and IPC

### B. FIELDS SEARCHED

Minimum documentation searched (classification system followed by classification symbols)

B22F3/00; B22F1/00; B22F3/14; B22F7/08

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| X | WO 2015/060346 A1 (HITACHI CHEMICAL CO., LTD.) 30 April 2015 (2015-04-30) paragraphs [0009]-[0013], [0022], [0042], [0043], [0056]-[0058], [0061]-[0063], [0067], [0072], [0096], [0103], [0107]-[0113], tables 2-4 | 1-6 |
| A | JP 2021-116463 A (MITSUBISHI MATERIALS CORP.) 10 August 2021 (2021-08-10) entire text, all drawings | 1-6 |
| A | JP 2021-116450 A (TAIYO NIPPON SANSO CORP.) 10 August 2021 (2021-08-10) entire text, all drawings | 1-6 |
| A | JP 2010-248617 A (NIPPON HANDA KK) 04 November 2010 (2010-11-04) entire text, all drawings | 1-6 |
| P, A | JP 2022-29194 A (ISHIHARA CHEMICAL CO., LTD.) 17 February 2022 (2022-02-17) paragraphs [0016]-[0035] | 1-5 |

☐ Further documents are listed in the continuation of Box C.      ☑ See patent family annex.

| | | |
|---|---|---|
| * | Special categories of cited documents: | |
| "A" | document defining the general state of the art which is not considered to be of particular relevance | |
| "E" | earlier application or patent but published on or after the international filing date | |
| "L" | document which may throw doubts on priority claim(s) or which is cited to establish the publication date of another citation or other special reason (as specified) | |
| "O" | document referring to an oral disclosure, use, exhibition or other means | |
| "P" | document published prior to the international filing date but later than the priority date claimed | |

"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **20 January 2023** | **28 March 2023** |

| Name and mailing address of the ISA/JP | Authorized officer |
|---|---|
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (January 2015)

<div align="center">

**INTERNATIONAL SEARCH REPORT**
**Information on patent family members**

</div>

International application No.

**PCT/JP2022/048667**

| Patent document cited in search report | | | Publication date (day/month/year) | Patent family member(s) | | | Publication date (day/month/year) |
|---|---|---|---|---|---|---|---|
| WO | 2015/060346 | A1 | 30 April 2015 | TW | 201535536 | A | |
| JP | 2021-116463 | A | 10 August 2021 | WO | 2021/153560 | A1 | |
| | | | | CN | 115023305 | A | |
| | | | | KR | 10-2022-0130689 | A | |
| JP | 2021-116450 | A | 10 August 2021 | WO | 2021/149496 | A1 | |
| | | | | TW | 202135175 | A | |
| | | | | CN | 114929413 | A | |
| | | | | KR | 10-2022-0130106 | A | |
| JP | 2010-248617 | A | 04 November 2010 | (Family: none) | | | |
| JP | 2022-29194 | A | 17 February 2022 | WO | 2022/030327 | A1 | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2021116463 A